# EUROPEAN PATENT SPECIFICATION

(11) **EP 0 695 478 B1**
(45) Date of publication and mention of the grant of the patent: **20.08.1997**
(21) Application number: 94914218.6
(22) Date of filing: 19.04.1994
(51) Int. Cl.: H03L 7/113

(54) **A PHASE LOCK LOOP WITH ERROR CONSISTENCY DETECTOR**
PHASENREGELKREIS MIT DETEKTION DER FEHLERKONSISTENZ
BOUCLE A VERROUILLAGE DE PHASE A DETECTEUR DE COHERENCE D'ERREUR

(30) Priority: 20.04.1993 GB 9308141; 04.06.1993 GB 9311560
(43) Date of publication of application: 07.02.1996
(73) Proprietor: RCA THOMSON LICENSING CORPORATION, Princeton, NJ 08540 (US)
(72) Inventor: SAUER, Donald, Jon, Allentown, NJ 08501 (US); RODDA, William, Trenton, NJ 08690 (US); CAMPBELL, Edward, Richard, III, Tabernacle, NJ 08088 (US); DELL'OVA, Francis, F-38720 Saint-Hilaire-du-Touvet (FR)
(74) Representative: Kurth, Dieter, Dipl.-Ing.
(86) International application number: US9404291
(87) International publication number: WO9424768

(56) References cited:
- US-A- 3 903 482
- US-A- 4 580 107
- US-A- 4 633 193
- US-A- 5 028 885
- US-A- 5 159 292
- IBM TECHNICAL DISCLOSURE BULLETIN, vol.23, no.1, 1 June 1980, NEW YORK, US pages 81 - 82 M. CARNES ET AL. 'Cycle Synchronised Phase-Locked Loop'

## Description

The invention relates to an arrangement for generating a clock signal.

Digital video signal processing systems with features such as on-screen display of text and picture-in-picture for both television receiver and video tape recorder signal sources may require a clock signal that is phase locked to a horizontal synchronization signal, referred to as line-locked clock. It may be advantageous to form a phase-locked loop (PLL) system for line-locked clock generation for use as a building block in large scale CMOS video signal processing integrated circuits. In such PLL, it may be desirable to have, for example, a clock frequency that ranges from 25 MHz to 40 MHz with a jitter that is less than 2nS. For such PLL it may be desirable to utilize only one pin for off-chip components. It may also be desirable to use the PLL system with each of the NTSC, PAL and SECAM systems. Example of relevant prior art is US-A-5 159 292.

It may also be advantageous to operate the PLL with an input sync signal encountered in low-cost consumer video tape recorders without time-base correction, where the horizontal sync can periodically make large phase changes such that the clock signal tracks such sync signal. It may be further desirable to rapidly reduce phase and frequency errors and minimize overshoot and jitter as the PLL settles into phase lock. In addition, it may be desirable to have the PLL discriminate between true output clock phase/frequency errors and those arising from contamination of the input horizontal sync signal with noise bursts or occasional missing pulses.

A PLL system, embodying an inventive feature, utilizes both digital and analog control of an R-C Voltage-Controlled Oscillator to acquire and maintain phase lock of an output clock with respect to an input horizontal sync signal. Depending on the magnitude and consistency of the output clock phase and frequency error, the system automatically selects one of, for example, five control modes of operation of varying sensitivity. The control modes of operation are such that large errors result in large, coarse corrective actions, and small errors result in small, or fine corrective actions.

In a PLL, embodying a different inventive feature, an error in a phase between a horizontal synchronization signal and an output signal of the oscillator is measured. When the phase error exceeds a first predetermined magnitude and provided that a difference between the phase error measured in each of a pair of horizontal line periods is smaller than a second predetermined magnitude, the phase error is corrected in a coarse phase error correction mode. The phase error difference that is smaller than the second predetermined magnitude is indicative of phase error consistency. On the other hand, when the phase error is inconsistent in the pair of periods, the phase error is not corrected and the PLL operates in an idle mode of operation.
Advantageously, by disabling the correction of the phase error when the phase error is inconsistent, an occasional noise in the synchronization signal is prevented from disturbing the steady state mode of operation. In this way, noise immunity is increased.

Similarly, when a difference between a frequency error measured in each of a pair of horizontal line periods is larger than a predetermined magnitude that is indicative of inconsistent frequency error, the frequency error is not corrected and the PLL operates in an idle mode of operation.
Advantageously, by disabling the correction of the frequency error when the frequency error is inconsistent, noise immunity is increased.

An apparatus, embodying an aspect of the invention as it is defined in the appended claims, for generating an oscillatory signal includes a controllable oscillator. A first signal that is indicative of one of a frequency and a phase error between the oscillatory signal and a synchronizing signal is provided. The first signal is coupled to a control input of the oscillator for correcting the oscillatory signal to correct for the error in a negative feedback loop manner. The error that is measured in a given pair of periods of the synchronizing signal is compared. The correction of the oscillatory signal is disabled when a difference between the error that is measured in the pair of periods is greater than a first value.
FIGURE 1 illustrates a block diagram of a phase-lock-loop (PLL), embodying an aspect of the invention;
FIGURES 2A, 2B and 2C illustrate a detailed schematic diagram of a programmable switched R-C voltage controlled oscillator of the PLL of FIGURE 1;
FIGURE 3 illustrates a switched capacitor arrangement of the oscillator of FIGURES 2A-2C;
FIGURE 4 illustrates waveforms useful for explaining the arrangement of FIGURES 2A-2C;
FIGURE 5 illustrates a flow chart useful for explaining the operation of the PLL of FIGURE 1;
FIGURES 6, 7A and 7B illustrate more detailed diagrams of portions of the PLL of FIGURE 1;
FIGURE 8 is a table useful for explaining the operation of a decoder of FIGURE 1;
FIGURES 9a-9c are waveforms useful for explaining the operation of the PLL of FIGURE 1;
FIGURE 10 illustrates a schematic of a charge pump stage of the PLL of FIGURE 1;
FIGURE 11 illustrates a detailed schematic of a phase detector of the PLL of FIGURE 1;
FIGURES 12a-12g illustrate waveforms useful for explaining the operation of the phase detector of FIGURE 11; and
FIGURES 13a-13d illustrate waveforms useful for explaining the operation of the charge pump stage of the PLL of FIGURE 1.

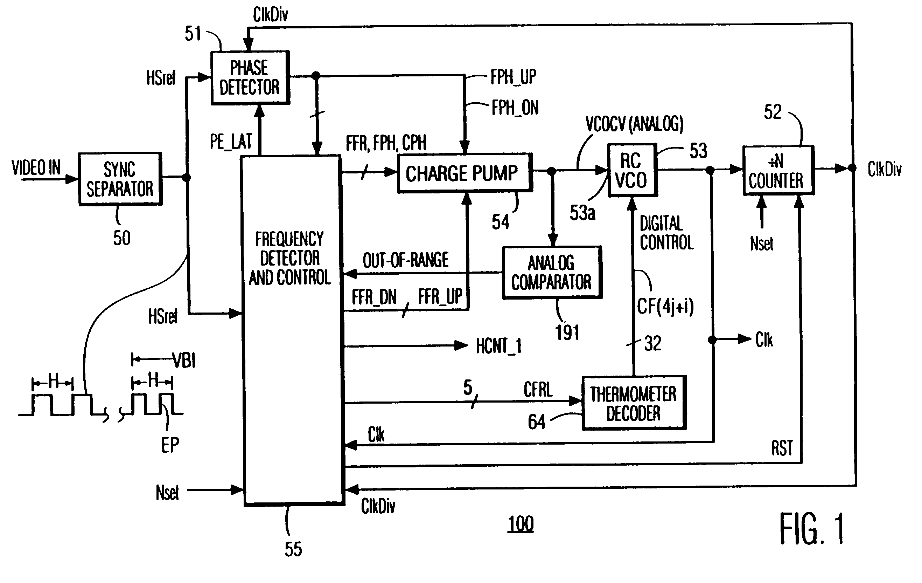

FIGURE 1 illustrates a block diagram of a phase-lock loop circuit (PLL) 100, embodying an aspect of the invention. A base band video signal VIDEO-IN obtained from, for example, a video detector, not shown, of a television receiver is coupled to a conventional sync separator 50 that generates pulses of a horizontal sync signal HSRef having a period H at a horizontal deflection frequency f_{H} that is in, for example, the NTSC standard 15,734 Hz.

An oscillatory signal ClkDiv is produced at an output of a programmable divide-by-N counter 52 by frequency dividing an output signal Clk of PLL 100 produced in a programmable, resistor-capacitor (R-C) type voltage-controlled-oscillator (RCVCO) 53. Output signal Clk may be used in various stages, not shown, of the television receiver for video signal processing. In steady state operation, the frequency of signal Clk is equal to N x f_{H}. The value N denotes a ratio between the frequency of signal Clk and that of signal ClkDiv. The value N that is selectable in the range of 750-2600 is provided by a constant digital word signal Nset that is coupled to counter 52 for presetting counter 52 once in each period of signal ClkDiv.

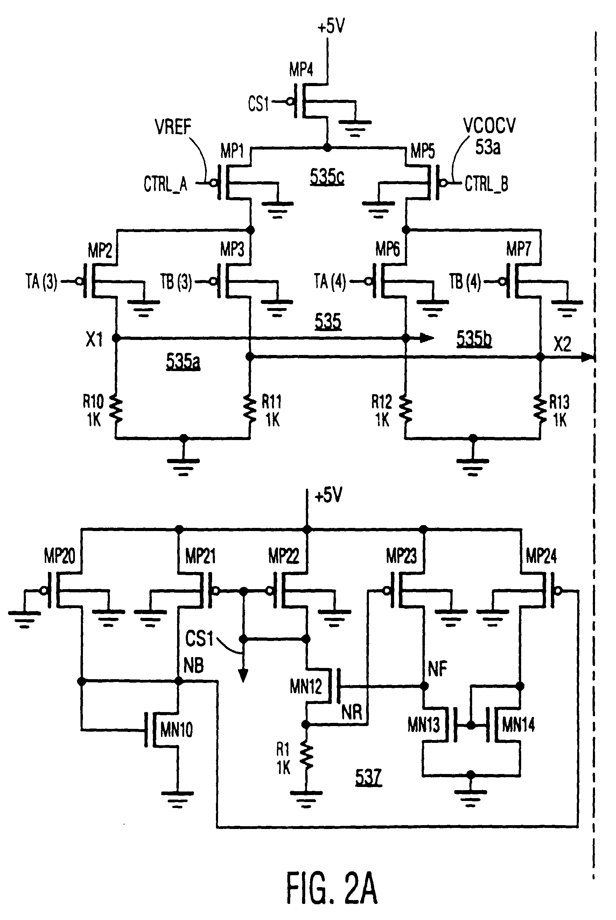

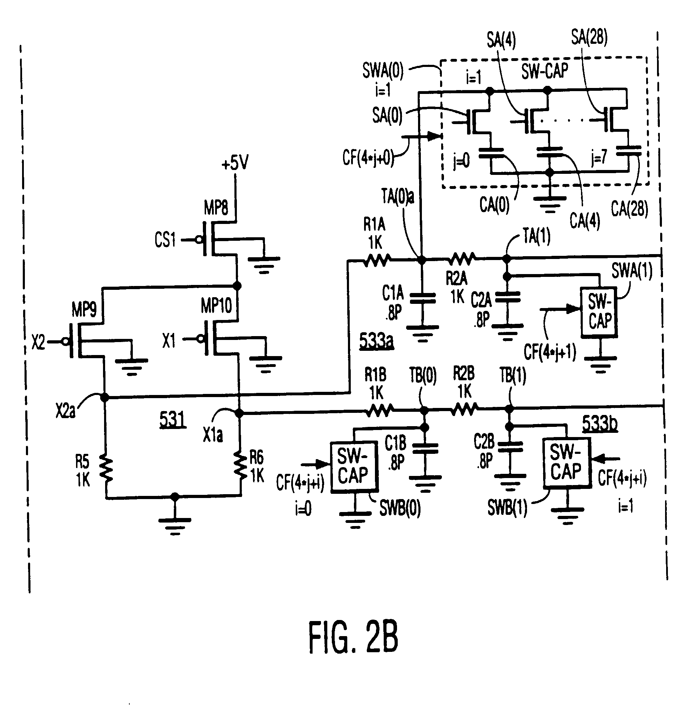

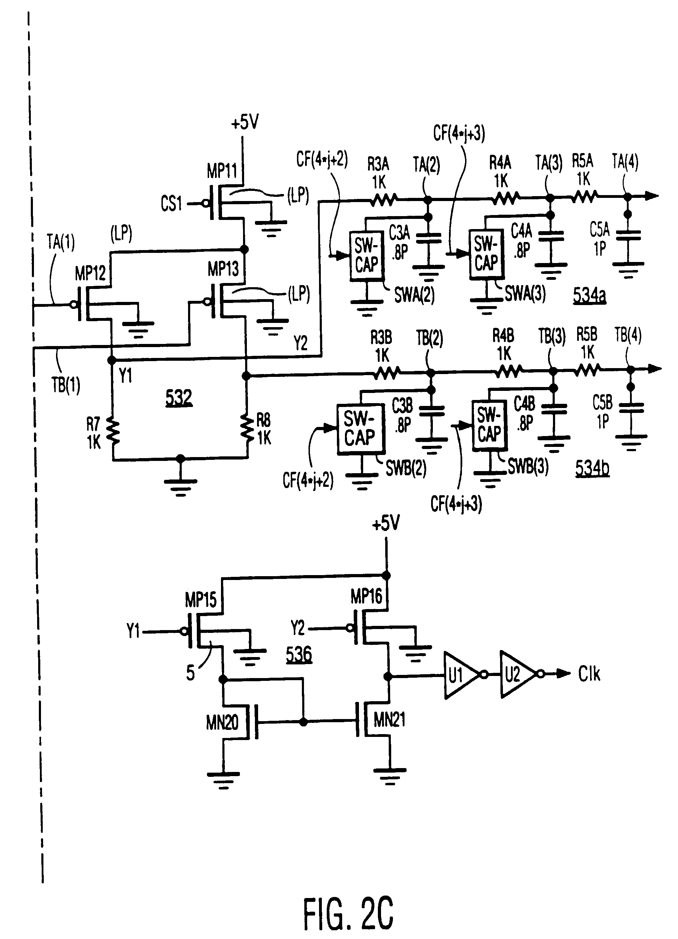

FIGURES 2A, 2B and 2C illustrate a schematic diagram of RCVCO 53 of FIGURE 1. Similar symbols and numerals in FIGURES 1 and 2A-2C indicate similar items or functions. RCVCO 53 of FIGURE 2B includes a differential amplifier 531 formed by a pair of transistors MP9 and MP10. A current source transistor MP8 produces a corresponding source electrode current in each of transistors MP9 and MP10. Amplifier 531 includes load resistors R5 and R6 of transistors MP9 and MP10, respectively. Similarly, a differential amplifier 532 of FIGURE 2C is formed by transistors MP11, MP12 and MP13 and load resistors R7 and R8. A pair of signals X2a and X1a developed in load resistors R5 and R6 of amplifier 531 are coupled to gate electrodes of transistors MP12 and MP13 via a pair of R-C delay networks 533a and 533b, respectively, that produce nominally the same phase shift. The phase shift produced by network 533a or 533b is controllable in a coarse frequency correction mode of operation, as explained later on. The phase shift determines, in part, the frequency of oscillation of signal Clk.

Delay network 533a includes a resistor R1A and a non-switched capacitor C1A. A switched capacitor bank SWA(0) is also coupled to capacitor C1A. A delayed signal TA(0) is developed at a junction terminal TA(0)a, between capacitor C1A and resistor R1A. Signal TA(0) is coupled via a resistor R2A to a capacitor C2A. A switched capacitor bank SWA(1) is also coupled to capacitor C2A. A delayed signal TA(1) is developed in capacitor C2A. Signal TA(1) is delayed with respect to signal TA(0). Similarly, network 533b includes a resistor R1B, a capacitor C1B and a bank SWB(0) that produces a signal TB(0). Network 533b includes a resistor R2B, a capacitor C2B and a bank SWB(1) that produces a signal TB(1).

A pair of signals Y1 and Y2 of FIGURE 2C developed in load resistors R7 and R8, respectively, of amplifier 532 are coupled via R-C delay networks 534b and 534a, respectively, that produce nominally the same phase shift. Networks 534a and 534b operate in a similar manner to networks 533a and 533b. Network 534a includes a resistor R3A, a capacitor C3A and a bank SWA(2) that produces a delayed signal TA(2). Signal TA(2) is coupled via a resistor R4A to a capacitor C4A and to a bank SWA(3) that produces a delayed signal TA(3). Signal TA(3) is further delayed via a resistor R5A and a capacitor C5A to produce a further delayed signal TA(4). Similarly, delay network 534b includes resistors R3B, R4B and R5B that are analogous to resistors R3A, R4A and R5A, respectively, and capacitors C3B, C4B and C5B that are analogous to capacitors C3A, C4A and C5A, respectively. Network 534b produces delayed signals TB(2), TB(3) and TB(4) that are analogous to signals TA(2), TA(3) and TA(4), respectively.

Signals TB(3) and TA(3) are coupled to gate electrodes of a pair of transistors MP3 and MP2, respectively, of an analog multiplier 535 of FIGURE 2A. Similarly, signals TB(4) and TA(4), that are delayed with respect to signals TB(3) and TA(3), respectively, are coupled to gate electrodes of a pair of transistors MP7 and MP6, respectively, of multiplier 535 of FIGURE 2A.

In multiplier 535, transistors MP2 and MP3 form a differential amplifier 535a having a controllable gain. Similarly, transistor MP6 and MP7 form a differential amplifier 535b having a controllable gain. The gains of amplifiers 535a and 535b vary in opposite directions in accordance with variations in drain currents produced by a pair of transistors MP1 and MP5 that form a differential amplifier 535c. The drain currents in transistors MP1 and MP2 vary in opposite directions in accordance with a voltage difference between gate electrodes of transistors MP1 and MP5.

A constant DC reference voltage VREF is developed at the gate of transistor MP1. A control, output signal VCOCV produced in a charge pump control stage 54 of FIGURE 1 is developed at the gate of transistor MP5 of FIGURE 2A to control the frequency/phase of signal Clk, in a fine error correction mode of operation, as explained later on.

The drain electrode of transistor MP2 is coupled to the drain electrode of transistor MP6 to develop a sum signal X1. Signal X1 is developed in a pair of parallel coupled load resistors R10 and R12 and is coupled to the gate electrode of transistor MP10 of amplifier 531 of FIGURE 2B. Similarly, the drain electrode of transistors MP3 of FIGURE 2A is coupled to the drain electrode of transistor MP7 to develop a sum signal X2. Signal X2 is developed in a pair of load resistors R11 and R13 and is coupled to the gate electrode of transistor MP9 of amplifier 531 of FIGURE 2B.

The signal gain, for example, via transistor MP2 varies in the opposite way to that via transistor MP6. The phase shift of signal X1 is determined by the vectorial sum of a pair of signals having a phase difference therebetween produced from the drain currents in transistors MP2 and MP6, respectively. Thus, the phase shift of signal X1 varies in a fine or gradual manner when analog signal VCOCV that is coupled to amplifier 535c varies in a gradual manner. Similarly, the phase shift of signal X2 also varies in a fine or gradual manner in accordance with signal VCOCV. Signal X1 is nominally at an opposite phase with respect to signal X2. Varying the phase shift of signal X1 or X2 causes the oscillation frequency of RCVCO 53 and of signal Clk to vary, as explained later on.

It may be desirable to achieve a wide frequency range of, for example, 25-40 MHz of signal Clk and also to compensate for tolerances, temperature variations and for aging in the R-C delay networks. The R-C delay networks are formed in RCVCO 53 using integrating circuit fabrication technique.

The frequency of RCVCO 53 can be stepped up or down in a coarse frequency correction mode of operation. For example, the coarse frequency correction mode may occur immediately after power is applied. To provide the coarse frequency correction mode, the aforementioned four switch-capacitor banks, SWA(i), are provided. The parameter "i" that designates the switch-capacitor bank assumes the four values, 0 to 3. Switch-capacitor banks SWA(i) are coupled to four corresponding terminals where signals TA(i), referred to before, are developed. Thus, a given bank SWA(i) is coupled to a corresponding terminal where signal TA(i) is designated by the same value "i". Similarly, the afore-mentioned four switch-capacitor banks, SWB(i), are coupled to corresponding four terminals where signal TB(i), referred to before, are developed. In the same way, the parameter "i" assumes the values 0 to 3.

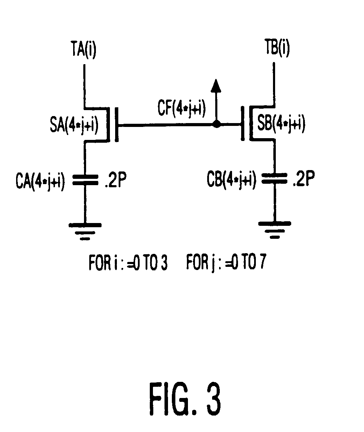

Each bank SWA(i), such as bank SWA(0) of FIGURE 2B, includes eight parallel coupled switch-capacitor arrangements. A given switch-capacitor arrangement of a given bank SWA(i) is formed by a transistor switch SA(4j+i), shown in FIGURE 3, that is coupled in series with a corresponding capacitor CA(4j+i). Similar symbols and numerals in FIGURES 1, 2A-2C and 3 indicate similar items or functions. For a given bank SWA(i) of FIGURES 2B and 2C, the parameter j assumes, selectively, one of the eight values 0 to 7.

A given transistor switch SA(4j+i) of FIGURE 3 is coupled in series with a corresponding capacitor CA(4j+i) such that the value of "i" is common to both switch SA(4j+i) and to capacitor C(4j+i) and the value of "j" is also common for both. Similarly, each bank SWB(i) of FIGURES 2B and 2C includes eight parallel coupled transistor switch-capacitor arrangements, such as, for example, bank SWA. Each of such eight arrangements is formed by a transistor switch SB(4j+i) of FIGURE 3 that is coupled in series with a capacitor CB(4j+i).

In each pair of banks, SWA(i) and SWB(i), of FIGURES 2B and 2C designated by a common value "i", such as, for example, banks SWA(0) and SWB(0), eight control signals CF(4j+i) control the corresponding eight pairs of transistor switches SA(4j+i) and SB(4j+i) designated also by the common value of "i" and the common value of "j". Signals CF(4j+i) are developed in a manner that is described later on. Thus, the total of 32 pairs of switches SA(4j+i) and SB(4j+i) are controlled by the 32 control signals CF(4j+i), respectively. The value of "i" for a given pair of switches SA(4j+i) of FIGURE 3 and SB(4j+i) and for control signal CF(4j+i) that controls such pair of switches is the same. The value of "j" is also common for the given pair of switches SA(4j+i) and SB(4j+i) and for control signal CF(4j+i) that controls such pair.

When a given control signal CF(4j+i) assumes a TRUE state, a corresponding capacitor CA(4j+i) of the corresponding bank SWA(i) and a corresponding capacitor CB(4j+i) of the corresponding bank SWB(i) are switched in or coupled via a pair of the switches SA(4j+i) and SB(4j+i) to the terminals where signals TA(i) and TB(i), respectively, are developed. Thereby, an increase phase delay and a corresponding decrease in the oscillation frequency of signal Clk of FIGURE 2C occur. On the other hand, when a given control signal CF(4j+i) of FIGURE 3 assumes a FALSE state, the corresponding pair of capacitors are switched out or decoupled, causing an increase in the oscillation frequency of signal Clk of FIGURE 2C.

A current mirror reference circuit 537 of FIGURE 2A includes a PMOS transistor MP20 that provides a small start-up current such as 1 µA. The start-up current causes a voltage level at a terminal NB to initially rise to a threshold voltage of a transistor MN10, typically 0.8V. Voltages at a terminal NR and at terminal NB are compared in a balanced PMOS current mirror amplifier formed by transistors MP23, MP24, MN13 and MN14.

Negative feedback from a terminal NF is applied to the gate of a transistor MN12 forcing the voltages at terminals NR and NB to be equal. The current flowing in a resistor R1 is, therefore, proportional to the voltage at terminal NB. Once current starts flowing in resistor R1, in transistor MN12 and in transistor MP22, additional current is sourced into terminal NB which causes the voltage at terminal NB to rise to a level of about 1.5V. Thus, a reference current flowing in transistor MP22 is nominally 0.25 mA.

An output voltage CS1 of current mirror reference circuit 537 developed at the drain of transistor MP22 is coupled to the gates of transistors MP4 and MP8 of FIGURE 2B and transistor MP11 of FIGURE 2C. As a result, the current flowing in transistor MP4 of FIGURE 2A is nominally 3 mA and the current flowing in each of the amplifiers sourced by transistors MP8 and MP11 is 1.5 mA. Circuit 537 of FIGURE 2A maintains stability of the frequency of the oscillator with respect to supply voltage change. Simulation shows that sensitivity to supply voltage change is 0.9%/V and to temperature change is -0.012%/°C.

RCVCO 53 of FIGURES 2A-2C is constructed in a differential symmetrical manner. Signals X2, Y1, TA(0), TA(1), TB(2), TB(3) and TB(4), defining a first positive feedback path, are differentially symmetrical with respect to signals X1, Y2, TB(0), TB(1), TA(2), TA(3) and TA(4), respectively, defining a second positive feedback signal path. Therefore, phase difference between a pair of differentially symmetrical signals such as, for example, signals Y1 and Y2 does not vary when the gain of, for example, amplifiers 535a and 535b of FIGURE 2A varies or when a temperature variation occurs. RCVCO 53 oscillates at a frequency which is determined by the total phase shift in its pair positive feedback paths.

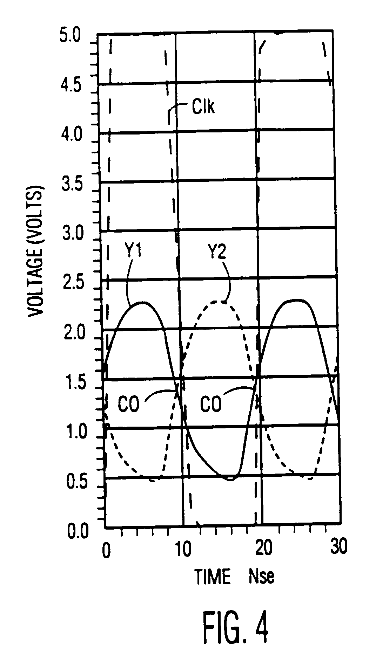

FIGURE 4 illustrates an example of simulated waveforms of signals Y1 and Y2 of FIGURE 1 when all the switched capacitors in RCVCO 53 are decoupled by signals CF(4j+i), resulting in maximum frequency or minimum period of signal Clk such as 19.62nS. Similar symbols and numerals in FIGURES 1, 2A-2C, 3 and 4 indicate similar items or functions.

As shown in FIGURE 4, signals Y1 and Y2 are nearly identical in magnitude and they are phased by 180 degrees with respect to each other. Signals Y1 and Y2 are differentially symmetrical signals because of the differential symmetrical configuration. Thus, crossover points in signals Y1 and Y2, such as points CO, that occur when the instantaneous values of signals Y1 and Y2 are simultaneously the same, occur at the opposite phase. Advantageously, the crossover points CO are nearly equally spaced in time as a result of the aforementioned differential symmetrical configuration. Because of the symmetrical configuration, the duty cycle of signal Clk is, advantageously, not affected by gain variations and temperature caused component variations. Therefore, advantageously, a relatively simple differential-to-single ended translation circuit 536 of FIGURE 2C that receives signals Y1 and Y2 and is formed by transistors MP15, MP16, MN20 and MN21 and gates U1 and U2 generates signal Clk at approximately 50% duty cycle. Furthermore, the differential symmetry configuration provides improved common mode noise rejection.

The measured noise bandwidth of RCVCO 53 is -30dB at 350 Hz. The short term stability of RCVCO 53 within 1 second is about ±150 Hz or 20 ppm, corresponding to a 1.3 ns jitter in one horizontal line period H of 63.5 µsec.

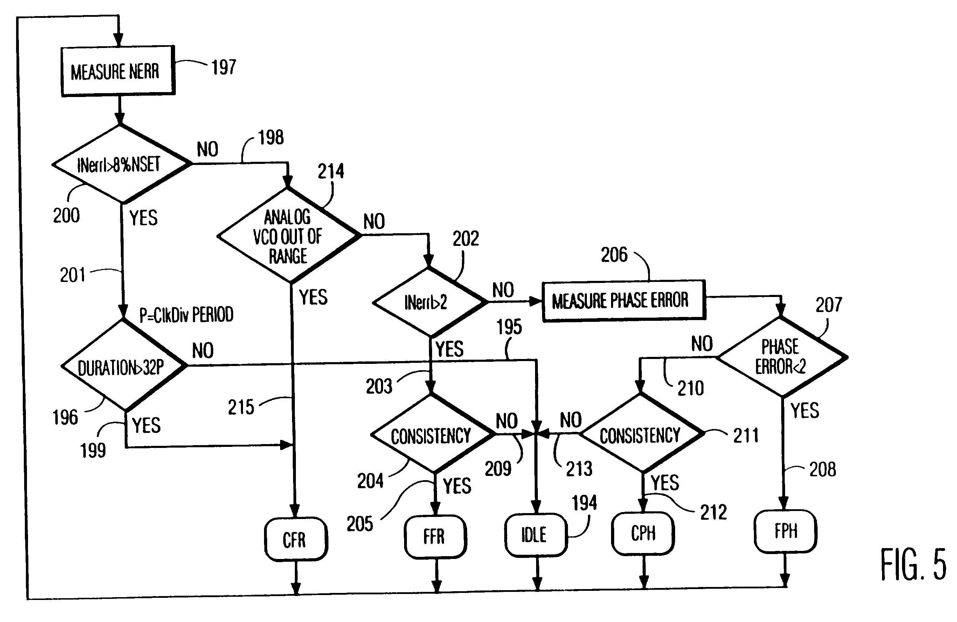

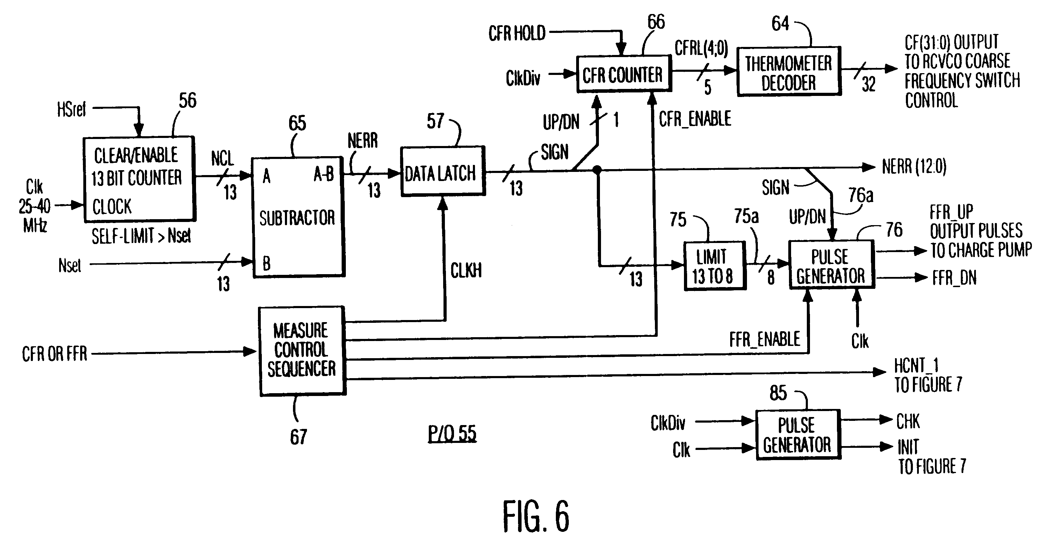

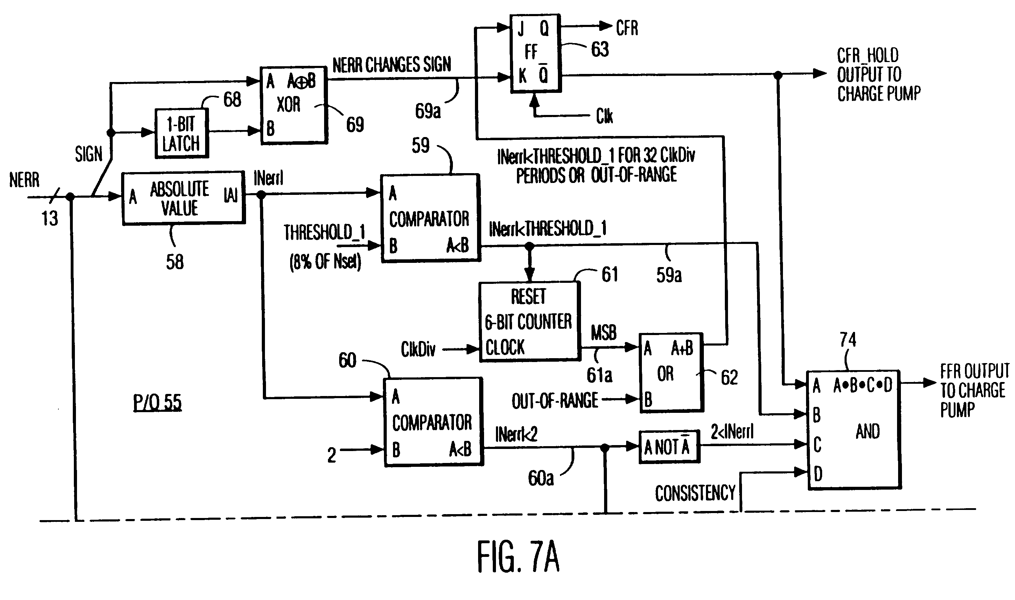

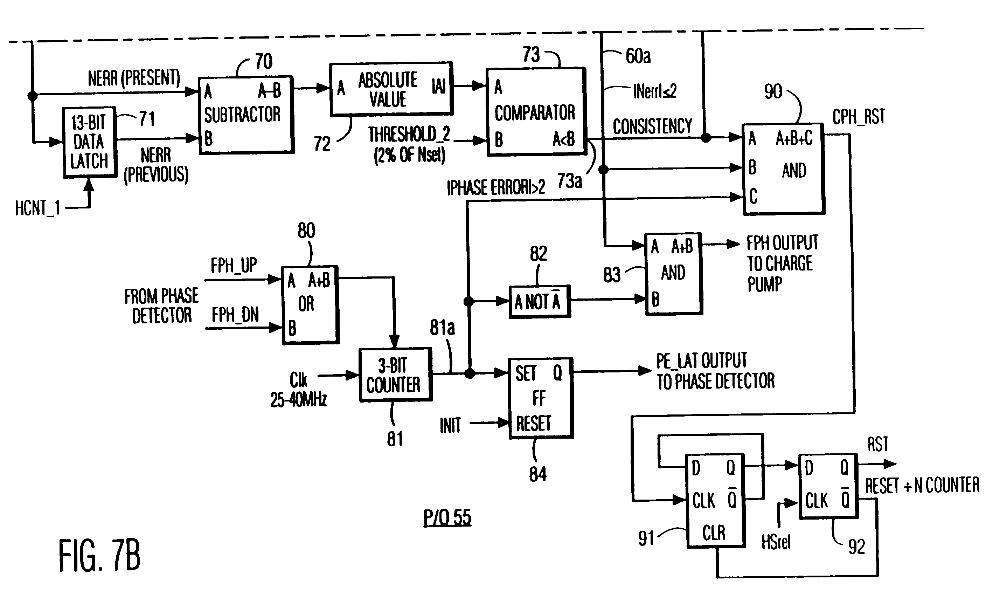

To control the frequency of RCVCO 53, sync signal HSRef of FIGURE 1 is coupled to a frequency detector and control stage 55. FIGURE 5 illustrates a flow chart useful for explaining the operation of PLL 100 of FIGURE 1. FIGURES 6, 7A and 7B illustrate corresponding portions of stage 55 of FIGURE 1 in more detailed block diagram. Similar symbols and numerals in FIGURES 1, 2A-2C, 3-6, 7A and 7B indicate similar items or functions.

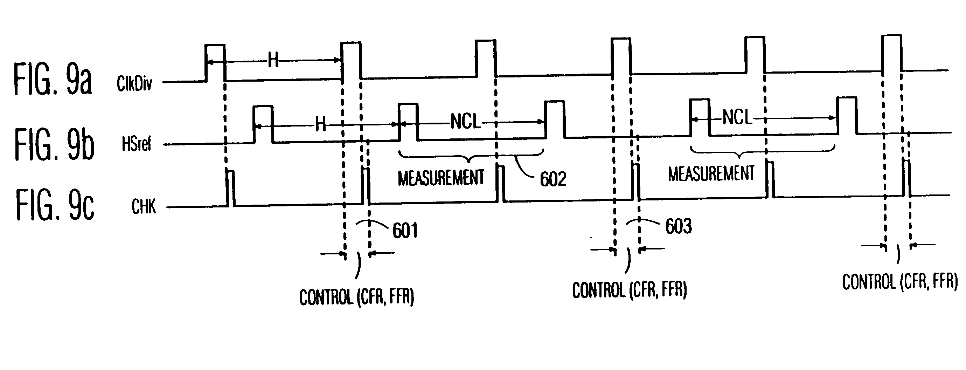

In the portion of stage 55 that is shown in FIGURE 6, signal HSRef is coupled to an input terminal Clear/Enable of a 13-bit-counter 56. Signal Clk of RCVCO 53 of FIGURE 1 is coupled to an input terminal CLOCK of counter 56 of FIGURE 6. FIGURES 9a and 9b illustrate an example of the pulses of signals ClkDiv and HSRef, respectively, of FIGURE 6. Similar symbols and numerals in FIGURES 1, 2A-2C, 3-6, 7A, 7B and 9A-9C indicate similar items or functions.

Counter 56 of FIGURE 6 counts pulses of signal Clk that occur during a given period H and referred to as an interval MEASUREMENT in FIGURE 9b. At the end of interval MEASUREMENT, counter 56 of FIGURE 6 contains a binary word signal NCL. Signal NCL has a numerical value that is equal to the number of clock pulses or periods of signal Clk that occur during a given period of signal HSRef. Thus, signal NCL contains the ratio between the frequency of signal Clk and that of signal HSRef.

Signal NCL is coupled to a subtractor 65 that generates a binary word signal Nerr by forming a difference between the value of signal NSET and that of signal NCL. Signal NSET is a constant binary word that is equal to the ratio between the frequency of signal Clk and that of signal ClkDiv, as indicated before. Signal Nerr is stored in a latch 57 when a timing control signal CLKH occurs. Signal CLKH occurs immediately following that period H of signal HSRef during which signal Nerr is measured and generated.

Stored signal Nerr is read out at an output of latch 57 as an output signal NERR. Error signal NERR has a value that is equal to a difference between the number of clock periods of signal Clk that occur during the given period MEASUREMENT of signal HSRef of FIGURE 9b and the number of clock periods of signal Clk of FIGURE 6 that occur during the period of signal ClkDiv of FIGURE 9a. Such difference is zero and represents no error, for example, when PLL 100 of FIGURE 1 is in a phase-lock condition. Thus, signal NERR is indicative of a cycle related or frequency error. The measurement operation in which signal NERR is developed is depicted in a flowchart path 197 of the flow chart of FIGURE 5.

Frequency error indicative signal NERR of FIGURE 6 is coupled to an input of an absolute value forming stage 58 of FIGURE 7A that produces a bianry word signal |Nerr|. Signal |Nerr| is equal to the absolute value of signal NERR. Signal |Nerr| is compared in a comparator 59 with a constant value word signal THRESHOLD_1 that is equal to 8% of the magnitude of word signal NSET. The desired period length of signal ClkDiv is contained in word signal NSET. Comparator 59 generates a word signal 59a when the error in the length of the period of signal ClkDiv, as measured by the number of clock cycles of signal Clk, is greater than 8% of the desired period length of signal ClkDiv.

Signal 59a is coupled to a reset input terminal RESET of a 6-bit counter 61 that counts up once in each period of clock signal ClkDiv, when counting is enabled in counter 61. Counter 61 produces a signal 61a, the most-significant-bit MSB of counter 61. Counting is enabled in counter 61 when signal 59a is generated.

Signal 61a is coupled via an OR gate 62 to a "J" input terminal of a flip-flop 63. A TRUE state of an output signal CFR of flip-flop 63 is obtained should, in each of the 32 immediately preceding periods H of signal ClkDiv, the error in the length of the period of signal ClkDiv, as provided by the value of signal |Nerr|, be greater than 8% of the desired period length.

As long as such 32 periods H of signal ClkDiv of FIGURE 9a have not elapsed, RCVCO 53 of FIGURE 1 is not affected, referred to as an idle mode operation and depicted in a path 194 of the flow chart of FIGURE 5. Advantageously, the idle mode occurs in a manner to prevents the occurrence of the coarse frequency correction mode, for example, throughout a vertical blanking interval (VBI). During the vertical blanking interval, equalizing pulses EP of FIGURE 1 occur. Pulses EP have a period that is one-half of period H. Therefore, equalizing pulses EP in signal HSRef of FIGURE 1 produce a value of error signal |Nerr| of FIGURE 7A that is greater than 8% of the desired period length. However, because the number of equalization pulses EP of FIGURE 1 is smaller than 32, counter 61 and "OR" gate 62 of FIGURE 7A prevent signal CFR from attaining the TRUE state, throughout the vertical blanking interval. Therefore, operation in the coarse frequency correction mode is prevented. As a result of the operation in the idle mode, advantageously, the phase of RCVCO 53 is not disturbed throughout the vertical blanking or retrace interval.

Assume that the number of periods of signal ClkDiv in which error signal |Nerr| is greater than 8% of the desired period length exceeds 32. This situation is indicative of a large frequency error not due to operation in the vertical blanking interval. Therefore, signal CFR of flip-flop 63 of FIGURE 7A would be generated at the TRUE state. When signal CFR is generated, it causes PLL 100 of FIGURE 1 to operate in the coarse frequency error correction mode of operation. During operation in the coarse frequency error correction mode, coarse frequency error is reduced sequentially in RCVCO 53 in switching steps. The way signal CFR is generated is indicated in flow chart paths 197, 200, 201, 196 and 199 of the flow chart in FIGURE 5.

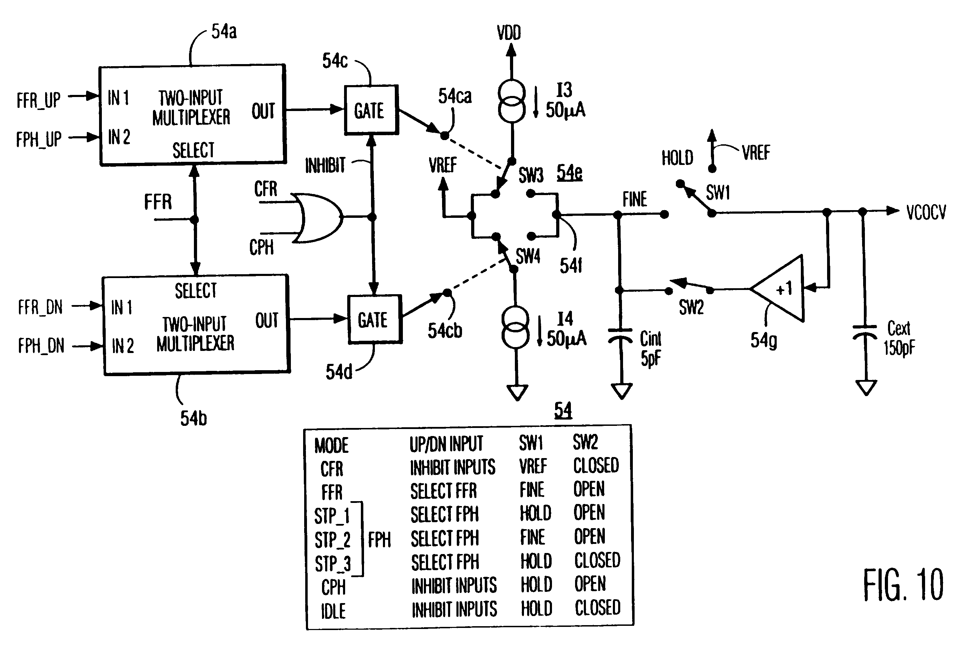

FIGURE 10 illustrates a more detailed diagram of charge pump stage 54 of FIGURE 1. Similar symbols and numerals in FIGURES 1, 2A-2C, 3-6, 7A, 7B, 9a-9c and 10 indicate similar items or functions. The table in FIGURE 10 provides the direction of signal flow and the state of the switches in stage 54. Throughout the coarse frequency error correction mode, charge pump stage 54 of FIGURE 10 produces analog control signal VCOCV of RCVCO 53 of FIGURE 2A at a constant level that is equal to reference voltage VREF, provided via a switch SW1 of FIGURE 10. Signal VCOCV of FIGURE 10 is established approximately at its middle voltage variation range.

In the coarse frequency error correction mode, a 5-bit binary counter 66 of FIGURE 6 counts up or down alternate pulses of signal ClkDiv. The direction of counting in counter 66, up or down, is determined in accordance with the state of a most significant or a sign bit SIGN of word signal NERR. A 5-bit output word signal CFRL(4:0) of counter 66 is coupled to an input of a decoder 64, referred to herein as a "thermometer" decoder. Thermometer decoder 64 produces the aforementioned 32 separate control signals CF(4j+i) by decoding the 5-bit signal CFRL(4:0).

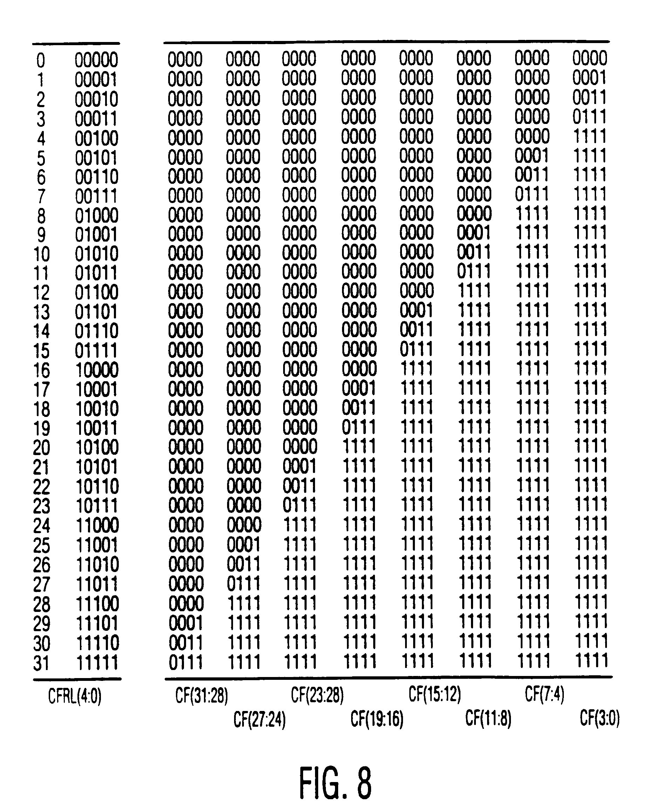

The table of FIGURE 8 shows those of signals CF(4j+i) of FIGURES 2A, 2B and 8 that are at the TRUE state and those that are at the FALSE state for each value of 5-bit word signal CFRL(4:0) of FIGURES 6 and 8. In the table of FIGURE 8, binary "1" represents the TRUE state and binary "0" represents the FALSE state. As shown in FIGURE 8, when counter 66 of FIGURE 6 counts up, only one of control signals CF(4j+i) of FIGURE 8 changes state. The change in state is from FALSE to TRUE state. Similarly, when counter 66 of FIGURE 6 counts down, only one of control signals CF(4j+i) of FIGURE 8 changes state; whereas, the change in state is from TRUE to FALSE.

In the coarse frequency error correction mode, a measure/control sequencer unit 67 of FIGURE 6 generates a signal CFR_Enable that enables counter 66 to count up/down alternate pulses of signal ClkDiv. Alternate pulses of signal ClkDiv occur in alternate periods H of signal HSRef. Only during intervals CONTROL, that occur in alternate periods of signal HSRef of FIGURE 9b, between intervals MEASUREMENT, signal CFR_Enable enables counter 66 of FIGURE 6 to change states. During the other alternate periods of signal HSRef of FIGURE 9b, when intervals MEASUREMENT occur, the value of signal NCL is measured, as explained before, but counter 66 of FIGURE 6 does not change states. Counter 66 does not change states while signals NERR or NCL of FIGURE 9b are being measured. By preventing counter 66 of FIGURE 6 from changing states, during a given interval MEASUREMENT of FIGURE 9b, the frequency of RCVCO 53 of FIGURE 1 does not change at the same time that the frequency of RCVCO 53 is being measured. Thus, a given switching step in the coarse frequency correction mode requires two horizontal clock pulses of signal ClkDiv and occurs every pair of periods H. As a result of not having the frequency of RCVCO 53 changed when it is being measured, a more stable and precise frequency control operation is obtained.

For explanation purposes of the coarse frequency error correction mode, assume that, in a given interval MEASUREMENT of FIGURES 9a and 9b, denoted as interval 602, the measured frequency of signal Clk of RCVCO 53 of FIGURES 2A-2C is higher than required. Such situation is indicated by the occurrence of a positive value of signal NERR of FIGURE 6. Consequently, at the end of the immediately following interval CONTROL of FIGURES 9a and 9b, denoted as interval 603, counter 66 of FIGURE 6 is incremented. The result is that a corresponding pair of capacitors CA(4j+i) and CB(4j+i) of FIGURES 2A, 2B and 2C are switched-in, in accordance with updated incremented value of word signal CFRL(4:0) of FIGURE 6. The updated value of signal CFRL(4:0) is incremented or decremented in accordance with the sign bit SIGN of signal NERR of FIGURE 6. Because additional pair of capacitors is coupled to the positive feedback paths, a decrease in the frequency of signal Clk occurs. On the other hand, if the frequency of signal Clk is lower than required, a pair of capacitors CA(4j+i) and CB(4j+i) of FIGURES 2B or 2C would be switched out or decoupled from the positive feedback paths. The capacitor switching occurs in the immediately following interval CONTROL, or interval 603, of FIGURES 9a and 9b, causing an increase in the frequency of RCVCO 53 of FIGURES 2A-2C.

Thermoter decoder 64 of FIGURE 6 operates in such a way that a change of state in counter 66 causes only one pair of switched capacitors in the corresponding pair of positive feedback paths, respectively, to be switched in or out and no other pair of capacitors is affected, as explained before. Therefore, advantageously, the change, increase or decrease, in the frequency of signal Clk of FIGURE 2C is monotonical and not affected by component tolerances. Thus, for the entire frequency range, the frequency of signal Clk is proportional to the value of word signal CFRL(4:0) of FIGURE 6.

For explanation purpose, assume that prior to the end of a given interval CONTROL, denoted as an interval 601, of FIGURES 9a and 9b, the value of signal CFRL(4:0) of FIGURE 6 is equal to 23. The value 23 corresponds to j=5 and i=3, since 4j+i=23. As explained before, i is selected only from the values 0 to 3 and, j is selected only from the values 0 to 7.

Further assume that the sign bit SIGN of signal NERR is such that counter 66 of FIGURE 6 counts up, at the end of interval 601. Thus, in a subsequent interval MEASUREMENT, denoted as an interval 602 of FIGURES 9a and 9b, signal CFRL(4:0) of FIGURE 6 contains an incremental value that is equal to 24, corresponding to j=6 and i=0 since 4j+i=24. Only capacitors CA(24) and CB(24) in banks SWA(0) and SWB(0), respectively, of FIGURE 2 will be switched in and coupled to the corresponding pair of positive feedback paths in RCVCO 53 at the end of interval 601 of FIGURES 9a and 9b. The switched capacitors that were already coupled to the corresponding positive feedback paths, prior to the end of interval 601 of FIGURES 9a and 9b, will not be affected by the increment of the value of signal CFRL(4:0) of FIGURE 8. In this way, capacitors CA(4j+i) and CB(4j+i) of FIGURES 2B and 2C are switched in or out in a progressive or monotonical manner.

In each interval CONTROL of FIGURE 9b, the change in the frequency of RCVCO 53 of FIGURES 2A-2C is approximately 4% of the entire range of operating frequencies of RCVCO 53. Thus, the entire frequency range of RCVCO 53 can be sequenced in 32 capacitor switching steps or fewer.

Sign bit SIGN of signal NERR of FIGURE 7A is coupled, both delayed and undelayed, to a pair of input terminals of an exclusive or gate 69. The delayed sign bit is produced in a latch 68. Gate 69 produces an output signal 69a that is coupled to a "K" input terminal of J-K flip-flop 63.

Advantageously, switched capacitors CA(4j+i) and CB(4j+i) are switched in or switched out of the positive feedback path in steps of a negative feedback loop. The generation of signal CFR is disabled and operation in the coarse frequency error control mode ceases when the difference between the measured and expected lengths of the period of signal ClkDiv, as determined by the sign bit SIGN of signal NERR, changes sign. The sign change of signal NERR is indicative of attaining a frequency error that is smaller or equal to 4% of the entire frequency range. Thereafter, counter 66 of FIGURE 6 ceases to change states and the last state of signals CFRL (4:0) and CF (4j+i) remains unchanged.

Signal NERR of FIGURE 7B is coupled to a first input A of a subtractor 70. Signal NERR, delayed via a latch 71 by one period of signal ClkDiv, is coupled to a second input B of subtractor 70. An absolute value of a difference between the input signals of subtractor 70 is obtained in an absolute value forming stage 72 and is compared in a comparator 73 against a value contained in a digital word signal THRESHOLD_2.

Assume that the period length error of signal ClkDiv changes, from a given period H to the immediately following one of signal ClkDiv, by less than 2% of the expected period length of clock signal ClkDiv. The 2% threshold value is contained in signal THRESHOLD_2. Therefore, a signal CONSISTENCY, embodying an inventive feature, is generated in an output 73a of comparator 73. Thus, signal CONSISTENCY is generated when the magnitude of signal NERR varies by no more than 2% of the value of signal NSET of FIGURE 6 from one clock period H to the immediately following one of signal ClkDiv. It follows that signal CONSISTENCY of FIGURE 7B is indicative of the presence of a stable and noise free synchronizing signal HSRef and error signal Nerr.

Signal |Nerr| of FIGURE 7A is compared with a constant value that is equal to 2 in a comparator 60. Comparator 60 generates a signal 60a when the error or difference in the period length of signal ClkDiv with respect to that of signal HSRef is smaller than 2 clock periods of signal Clk.

Assume that all of the followings occur: signal CONSISTENCY of FIGURE 7A is produced, the value of signal |Nerr| is greater than or equal to 2, but smaller than 8% of the value of signal Nset, as provided in signal 60a of FIGURE 7A and signal CFR is not generated. Therefore, an "AND" gate 74 produces a signal FFR. Signal FFR initiates and establishes a fine or gradual frequency error correction mode of operation in which the state of coupling or decoupling of the switched capacitor in FIGURES 2A-2C is not affected. Flow chart paths 202, 203, 204 and 205 in the flow chart of FIGURE 5 depict the conditions for the generation of signal FFR of FIGURE 7A. On the other hand, should signal CONSISTENCY not be generated, RCVCO 53 of FIGURE 1 will not be affected, resulting in the aforementioned idle mode of operation, as depicted in flow chart paths 197, 204 and 209 of the flow chart of FIGURE 5.

In the fine frequency error correction mode, signal FFR of FIGURE 7A controls the operation of charge pump stage 54 of FIGURE 10 for varying analog signal VCOCV. Variation of signal VCOCV causes the frequency of RCVCO 53 of FIGURE 1 to vary in a gradual manner and without switching steps of the switched capacitor, unlike in the coarse frequency error correction mode.

Signal NERR of FIGURE 6 is coupled through a word limiter 75 to a pulse generator 76. Limiter 75 produces an eight-bit, 2's complement word signal 75a from the least significant eight bits of signal NERR. Signal NERR is a 13-bit word signal. Should the magnitude of signal NERR be larger than what can be represented by eight-bit word signal 75a, signal 75a would be established at a value that is equal to the upper limit, positive or negative, of an eight-bit, 2's complement word. Word signal 75a is stored in a binary counter, not shown, of a pulse generator 76. Pulse generator 76 generates a pulse of a signal FFR_UP or a pulse of a signal FFR_DN, in accordance with bit SIGN of signal NERR.

A given pulse of output signal FFR_UP has a pulse width that is proportional to the magnitude of error signal NERR and is produced when the value of signal NERR is negative. Signal FFR_UP occurs when the frequency of signal Clk is lower than required. Similarly, a given pulse of signal FFR_DN has a pulse width that is proportional to the magnitude of signal NERR and occurs when the frequency of signal Clk is higher than required.

Under the control of signal FFR, signal FFR_UP or FFR_DN of FIGURE 10 is selected and coupled through the corresponding one of a pair of two-input multiplexers 54a and 54b and through the corresponding one of a pair of gates 54c and 54d to the corresponding one of a pair of control terminals 54ca and 54cb of the corresponding one of a pair of switches SW3 and SW4. When the pulse of signal FFR_UP is generated, switch SW3 couples a positive pulse current I3 to a terminal 54f. Similarly, when the pulse of signal FFR_DN is generated, switch SW4 couples a negative pulse current I4 to terminal 54f.

A capacitor Cint, formed using an integrating circuit fabrication technique, is coupled in parallel with a discrete capacitor Cext via switch SW1. This is done by having the selector of switch SW1 coupled to terminal 54f in the fine frequency correction mode. The control of switch SW1 is shown by the table in FIGURE 10. Consequently, capacitors Cext and Cint are charged in parallel, when signal FFR_UP is produced, by an amount that is proportional to the pulse width of signal FFR_UP. Capacitors Cext and Cint are discharged, in a similar manner, when signal FFR_DN occurs. Signal VCOCV is produced in capacitor Cext and is coupled to RCVCO 53 of FIGURE 2A.

Similarly to the coarse frequency error correction mode, and for similar reasons, during intervals MEASUREMENT, that occur during alternate periods H of signal HSRef of FIGURE 9b, the frequency of signal Clk does not change simultaneously with the measurement of the frequency error. Charging/discharging of capacitors Cint and Cext of FIGURE 10, in accordance with signal NERR, is enabled only during the other alternate periods intervals CONTROL of signal HSRef of FIGURE 9b. During operation in the fine frequency error correction mode, the difference between the period length of signal ClkDiv and that of signal HSRef is brought to within 2 period length of signal Clk or approximately 0.2% of period H of signal HSRef.

The correction range that is produced by signal VCOCV in the fine frequency error correction mode is approximately ±8 % of the entire frequency range of RCVCO 53 of FIGURES 2A-2C. Therefore, advantageously, signal VCOCV has a sufficiently large range that overlaps each range of frequencies associated with a given switching step of signals CF(4j+i) that occurs in the coarse frequency error correction mode. This is so because, as explained before, the range of frequencies associated with a given switching step in the coarse frequency error correction mode is equal to approximately 4% of the entire frequency range of RCVCO 53. Advantageously, the correction range of signal VCOCV is still sufficiently small so that sensitivity to noise is reduced.

In carrying out an inventive feature, when signal CONSISTENCY of FIGURE 7B is not generated, the idle mode of operation occurs. The idle mode occurs when, for example, signal HSRef of FIGURE 1 is contaminated with noise. In the idle mode that occurs as a result of signal CONSISTENCY not being generated, switch SW1 of FIGURE 10 decouples capacitor Cext from terminal 54f. Therefore, capacitor Cext of FIGURE 10 is neither charged nor discharged and signal VCOCV is maintained relatively constant. In the idle mode, signal VCOCV is coupled via a unity gain amplifier and a switch SW2 to capacitor Cint such that the capacitor voltage in terminal 54f of capacitor Cint tracks the voltage of signal VCOCV. The control of switch SW2 is shown by the table in FIGURE 10.

Assume that after an interruption interval in signal HSRef of FIGURE 1, normal operation signal HSRef is restored such that signal CONSISTENCY of FIGURE 7B is again produced. Because of the operation in the idle mode, signal VCOCV of FIGURE 10 is not disturbed and is more likely to be already maintained at the approximately required level for steady state phase lock operation after the interruption interval in signal HSRef has ended. Thus, transient condition in PLL 100 of FIGURE 1 may be, advantageously, of short duration.

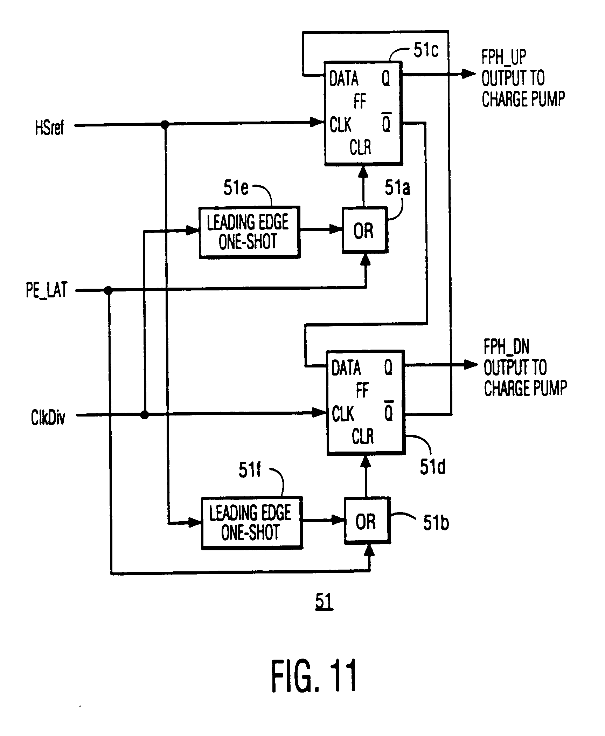

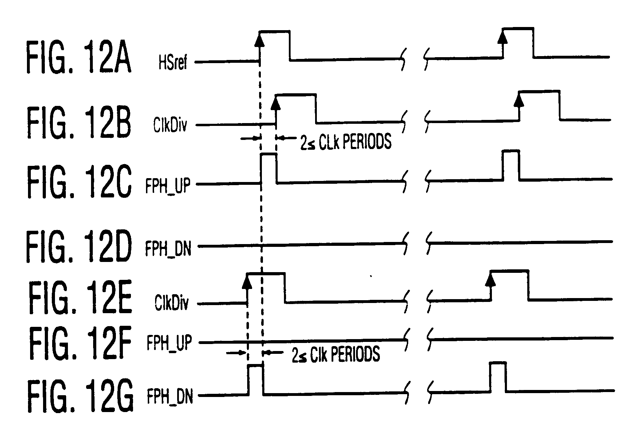

FIGURE 11 illustrates in more detail a phase detector 51 of FIGURE 1 that is used in a phase error correction mode of operation. FIGURES 12a-12g illustrate corresponding waveforms. Similar symbols and numerals in FIGURES 1, 2A-2C, 3-6, 7A, 7B, 8, 9a-9c, 10, 11 and 12a-12g indicate similar items or functions. Detector 51 of FIGURE 11 includes a D-type flip-flop 51c that is clocked by signal HSRef and reset by signal ClkDiv. Flip-flop 51c generates a given pulse of signal FPH_UP of FIGURE 12c when the leading edge of signal ClkDiv of FIGURE 12b lags behind that of signal HSRef of FIGURE 12a. A D-type flip-flop 51d of FIGURE 11 is clocked by signal ClkDiv and reset by signal HSRef via a one-shot multivibrator 51f. Flip-flop 51d generates a given pulse of signal FPH_DN of FIGURE 12g, when the leading edge of signal ClkDiv of FIGURE 12e leads that of signal HSRef of FIGURE 12a. The pulse width of each of pulse signals FPH_UP and FPH_DN is proportional to the phase difference. Only one of pulse signals FPH_UP and FPH_DN can be generated at a given period H.

Pulse signal FPH_UP or FPH_DN of FIGURE 7B is coupled via an "OR" gate 80 to a 3-bit binary counter 81. When the pulse width of either pulse is smaller than 2 clock periods of signal Clk, that is indicative of a relatively small phase error, an output signal 81a is at a FALSE level. Signal 81a is coupled via an inverter 82 to an input B of an "AND" gate 83. Frequency error indicative signal 60a is coupled to a second input A of gate 83. Signal 60a is generated when signal |Nerr| is smaller than 2, representing 2 clock periods of signal Clk.

For example, following operation in the fine frequency error correction mode, when both the phase error is small, as indicated by signal 81a being at the FALSE level, and the frequency error is small, as indicated by the generation of signal 60a, gate 83 generates a signal FPH. As a result, a fine phase error correction mode occurs. Flow chart paths 202, 206, 207 and 208 in the flow chart of FIGURE 5 depict the way the fine phase error correction mode is obtained.

In the fine phase error correction mode, unlike in the fine and coarse frequency error correction modes, the phase error is both measured and corrected in each period H of signal HSRef of FIGURE 9b. In the fine phase error correction mode, analog signal VCOCV of FIGURE 10 that is proportional to the phase error is used to acquire and maintain phase lock condition.

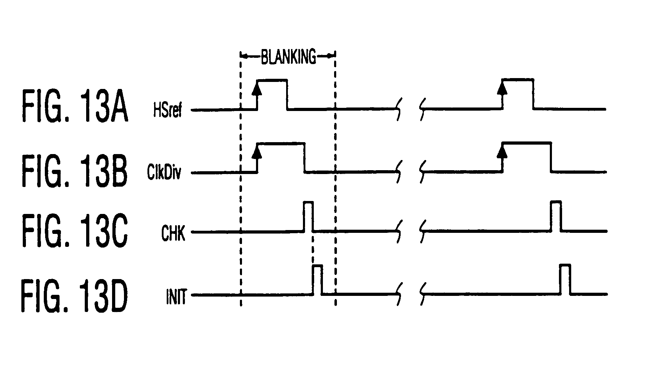

FIGURES 13a-13d illustrate waveforms useful for explaining the operation in the fine phase error correction mode. Similar symbols and numerals in FIGURES 1, 2A-2C, 3-6. 7A, 7B, 8, 9a-9c, 10, 11, 12a-12g and 13a-13d indicate similar items or functions.

When signal FPH of FIGURE 7B is generated, signal FPH_UP, alternatively, FPH_DN, of FIGURE 10 is coupled through multiplexers 54a and 54b and through gates 54c and 54d to terminals 54ca and 54cb of switches SW3 and SW4, respectively. Signal FPH_UP, alternatively, FPH_DN is applied to capacitors Cint and Cext in the following three operation sequence that occurs during each period of signal ClkDiv of FIGURE 13B.

In the first operation of the aforementioned three operation sequence, switch SW1 of FIGURE 10 is at a position HOLD. Should the pulse of signal FPH_UP be generated, switch SW3 would couple positive pulse current I3 to terminal 54f. Similarly, should the pulse of signal FPH_DN be generated, switch SW4 would couple negative pulse current I4 to terminal 54f. Capacitor Cint is charged when signal FPH_UP is produced by an amount that is proportional to its pulse width and is discharged when signal FPH_DN is produced. Thus, capacitor Cint and currents I3 and I4 operate as an integrator or a low pass loop filter that develops in capacitor Cint a voltage proportional to the phase error.

In the second operation of the sequence, a pulse generator 85 of FIGURE 6 generates a pulse signal CHK of FIGURES 6 and 13c following the trailing edge of signal ClkDiv of FIGURE 13B. Pulse signal CHK of FIGURE 6 causes, in a manner not shown, switch SW2 of FIGURE 10 to open and switch SW1 to couple capacitor Cext to terminal 54f. Thus, capacitors Cint and Cext are coupled in parallel. Therefore, the charge in capacitor Cext varies in accordance with that of capacitor Cint and is determined by the measured phase error. In this way, charge transfer occurs between capacitors Cext and Cint.

In the third operation of the sequence, generator 85 of FIGURE 6 generates a pulse signal INIT of FIGURES 6 and 13d following pulse signal CHK of FIGURE 13c. Pulse INIT causes, in a manner not shown, switch SW1 of FIGURE 10 to be in position HOLD and switch SW2 to be closed. In this way, the initial condition voltage is maintained in capacitor Cint the same as in larger capacitor Cext in preparation for the next first operation in the next three operation sequence the next three operation sequence occurs in the next period of signal ClkDiv. Advantageously, signal ClkDiv may suffer from less than, for example, 2 ns jitter in the fine phase correction mode.

Fine frequency/phase control signal VCOCV of FIGURE 1 is also coupled to a comparator 91. A signal OUT-OF-RANGE would be generated by comparator 91 should the magnitude of signal VCOCV be outside a predetermined voltage range. Signal OUT-OF-RANGE is indicative of a situation in which signal VCOCV approaches a magnitude that is outside a linear control range of operation of RCVCO 53. When signal OUT-OF-RANGE is produced, PLL 100 begins operating in the coarse frequency control mode that was explained before. Flow chart paths 214 and 215 in the flow chart of FIGURE 5 depict such situation.

Should the phase error be large, resulting in a time difference between the leading edge of signal HSRef of FIGURE 12a and that of signal ClkDiv of FIGURE 12b or 12c that is equal to or greater than 2 clock periods of signal Clk of FIGURE 7B, signal 81a would be generated. Signal 81a causes a flip-flop 84 to be "set" and to generate an output signal PE_LAT. Signal PE_LAT is coupled to flip-flop 51c and 51d of phase detector 51 of FIGURE 11 via "OR" gates 51a and 51b for terminating or producing a trailing edge of the then occurring pulse of signal FPH_UP or FPH_DN. Thus, advantageously, in the fine phase error correction mode, when detector 51 controls stage 54 of FIGURE 10, detector 51 of FIGURE 11 is prevented from varying the frequency/phase of signal Clk by an excessive amount in each period of signal ClkDiv.

Signal 81a of FIGURE 7B at the TRUE level that is indicative of a large phase error is coupled to an input C of an "AND" gate 90. Signal CONSISTENCY that is indicative of consistent frequency error from one period H of signal HSRef of FIGURE 9b to the immediately next one, as explained before, is coupled to a second input A of gate 90 of FIGURE 7B. Signal 60a that is indicative of a small frequency error, when the value of signal |Nerr| is smaller than 2, is coupled to a third input B of gate 90. Gate 90 generates a signal CPH_RST when all the three signals, 81a, 60a and CONSISTENCY, are generated. Signal CPH_RST is coupled to a clock input of a D-type flip-flop 91. An output Q of flip-flop 91 is coupled to an input D of a D-type flip-flop 92 that produces a pulse signal RST when the leading edge of signal HSRef occurs following the generation of signal CPH_RST.

Signal RST is coupled to öN counter 52 of FIGURE 1 for presetting the flip-flops, not shown, of counter 52 in a manner to provide an immediate phase lock between signals HSRef and ClkDiv. Thus, signal RST provides a coarse phase error correction mode of operation. Flow chart paths 210, 211 and 212 in the flow chart of FIGURE 5 depict the way the coarse phase correction mode is obtained. This mode can occur when, for example, the phase of signal HSRef of FIGURE 1 that is produced in a video tape recorder, changes abruptly, during a vertical retrace interval of a playback mode. The coarse phase error correction is accomplished via a signal path between RCVCO 53 of FIGURE 1 and phase detector 51 in a manner that bypasses the signal path of signal VCOCV. As a result of the abrupt or coarse phase correction, the phase of signal ClkDiv is aligned with that of signal HSRef without significantly affecting the phase of signal Clk. In this way, advantageously, transient disturbance in RCVCO 53 is eliminated or significantly reduced.

In carrying out a further inventive feature, should signal 81a of FIGURE 7B that is indicative of a large phase error be generated and signal CONSISTENCY, that is indicative of a stable sync signal HSRef, not be generated, signal RST would not be generated and the idle mode of operation would occur. Flow chart path 213 in the flow chart of FIGURE 5 depicts this way in which the idle mode is obtained. The advantage of operating in the idle mode and preventing the coarse phase error correction when signal CONSISTENCY of FIGURE 7B is not generated is that disturbance or transient in PLL 100 of FIGURE 1 may be reduced. Such disturbance may be reduced when, for example, the duration of the interruption in signal HSRef is short.

## Claims

1. An apparatus for generating an oscillator signal that is locked to a synchronizing signal, comprising:
a controllable oscillator for generating said oscillatory signal;
a source of said synchronizing signal at a frequency that is related to a scanning frequency;
means responsive to said oscillatory and synchronizing signals for generating a first signal that is indicative of a cycle related error therebetween, said first signal being coupled to a control input of said oscillator for correcting said cycles of said oscillatory signal to correct for said error in a negative feedback loop manner; and
means coupled to said first signal generating means for comparing said error that is measured in a given pair of periods of said synchronizing signal and for disabling the correction of said oscillatory signal when a difference between said error that is measured in one of said pair of periods and said error that is measured in the other one of said pair of periods is greater than a first value.

2. An apparatus according to Claim 1 wherein said first signal is indicative of frequency error.

3. An apparatus according to Claim 2 wherein when said frequency error between said oscillatory and synchronizing signals exceeds a second value and said difference is smaller than said first value, said apparatus operates in a fine frequency error correction mode and when said frequency error is smaller than said second value said apparatus operates in a phase error correction mode.

4. An apparatus according to Claim 1 wherein said first signal generating means comprises a phase detector for generating a signal that is indicative of a phase error between said oscillatory and synchronizing signals, wherein said disabling means comprises means for measuring said difference between a frequency error in a first period of said pair of periods and a frequency error in a second period of said pair of periods and wherein when said phase error exceeds a second value and said difference is indicative of said frequency error that is not inconsistent, said apparatus operates in a coarse phase error correction mode.

5. An apparatus according to Claim 1 wherein said error comparing means compares said error that is measured during a first horizontal line period with said error that is measured during a second horizontal line period.

6. An apparatus according to Claim 1 wherein said difference is indicative of an inconsistency of said error.

## Patentansprüche

1. Vorrichtung zur Erzeugung eines schwingenden Signals, das mit einem Synchronsignal verriegelt ist, umfassend:
einen steuerbaren Oszillator zur Erzeugung des schwingenden Signals;
eine Quelle für das Synchronsignal mit einer Frequenz, die auf eine Abtastfrequenz bezogen ist;
auf das schwingende und das Synchronsignal ansprechende Mittel zur Erzeugung eines ersten Signals, das einen zyklusbezogenen Fehler zwischen diesen anzeigt, wobei das erste Signal einem Steuereingang des Oszillators zugeführt wird, um die Zyklen des schwingenden Signals zu korrigieren, damit der Fehler in der Art einer negativen Rückkopplungsschleife korrigiert wird; und
mit den ersten Signalerzeugungsmitteln verbundene Mittel, um den in einem gegebenen Paar von Perioden des Synchronsignals gemessenen Fehler zu vergleichen, und um die Korrektur des schwin-genden Signals unwirksam zu machen, wenn eine Differenz zwischen dem in einer Periode des Perioden-Paars gemessene Fehler und dem in der anderen Periode des Perioden-Paars gemessenen Fehler grö-ßer als ein erster Wert ist.

2. Vorrichtung nach Anspruch 1, bei der das erste Signal einen Frequenzfehler anzeigt.

3. Vorrichtung nach Anspruch 2, bei der diese, wenn der Frequenzfehler zwischen dem schwingenden und dem Synchronsignal einen zweiten Wert überschreitet, und die Differenz kleiner als der erste Wert ist, in einer feinen Frequenzfehler-Korrektur-Betriebsart arbeitet, und bei der diese, wenn der Frequenzfehler kleiner als der zweite Wert ist, in einer Phasenfehler-Korrektur-Betriebsart arbeitet.

4. Vorrichtung nach Anspruch 1, bei der die ersten Signalerzeugungsmittel einen Phasendetektor zur Erzeugung eines Signals umfassen, das einen Phasenfehler zwischen dem schwingenden und dem Synchronsignal anzeigt, wobei die Mittel zum Unwirksammachen Mittel umfassen, um die Differenz zwischen einem Frequenzfehler in einer ersten Periode des Perioden-Paares und einem Frequenzfehler in einer zweiten Periode des Perioden-Paares zu messen, und wobei die Vorrichtung, wenn der Phasenfehler einen zweiten Wert überschreitet und die Differenz anzeigt, daß der Frequenzfehler nicht inkonsistent ist, in einer groben Phasenfehler-Korrektur-Betriebsart arbeitet.

5. Vorrichtung nach Anspruch 1, bei der die Fehler-Vergleichsmittel den Fehler, der während einer ersten Horizontal-Zeilenperiode gemessen wird, mit dem Fehler vergleichen, der während einer zweiten Horizontal-Zeilenperiode gemessen wird.

6. Vorrichtung nach Anspruch 1, bei der die Differenz eine Inkonsistenz des Fehlers anzeigt.

## Revendications

1. Dispositif de génération d'un signal oscillant asservi à un signal de synchronisation, comprenant:
un oscillateur, pouvant être commandé, pour générer ledit signal oscillant;
une source dudit signal de synchronisation à une fréquence liée à une fréquence de balayage;
un moyen réagissant auxdits signaux oscillant et de synchronisation pour générer un premier signal indicateur d'une erreur entre ceux-ci liée aux cycles, ledit premier signal étant couplé à une entrée de commande dudit oscillateur pour corriger lesdits cycles dudit signal oscillant afin de corriger ladite erreur par contre-réaction; et
un moyen couplé audit moyen de génération d'un premier signal pour comparer ladite erreur mesurée dans une paire donnée de périodes dudit signal de synchronisation et pour interdire la correction dudit signal oscillant lorsqu'une différence entre ladite erreur mesurée dans l'une de ladite paire de périodes et ladite erreur mesurée dans l'autre de ladite paire de périodes est supérieure à une première valeur.

2. Dispositif selon la revendication 1, dans lequel ledit premier signal est indicateur d'une erreur de fréquence.

3. Dispositif selon la revendication 2, dans lequel ledit dispositif fonctionne dans un mode de correction fine d'erreur de fréquence lorsque ladite erreur de fréquence entre lesdits signaux oscillant et de synchronisation dépasse une deuxième valeur et ladite différence est inférieure à ladite première valeur, et ledit appareil fonctionne dans un mode de correction d'erreur de phase lorsque ladite erreur de fréquence est inférieure à ladite deuxième valeur.

4. Dispositif selon la revendication 1, dans lequel ledit moyen de génération d'un premier signal comprend un comparateur de phase pour générer un signal indicateur d'une erreur de phase entre lesdits signaux oscillant et de synchronisation, dans lequel ledit moyen d'interdiction comprend un moyen pour mesurer ladite différence entre une erreur de fréquence dans une première période de ladite paire de périodes et une erreur de fréquence dans une deuxième période de ladite paire de périodes, et dans lequel ledit dispositif fonctionne dans un mode de correction approximative d'erreur de phase lorsque ladite erreur de phase dépasse une deuxième valeur et ladite différence indique que ladite erreur de fréquence n'est pas incohérente.

5. Dispositif selon la revendication 1, dans lequel ledit moyen de comparaison d'erreurs compare ladite erreur mesurée pendant une première période de ligne horizontale à ladite erreur mesurée pendant une deuxième période de ligne horizontale.

6. Dispositif selon la revendication 1, dans lequel ladite différence indique une incohérence de ladite erreur.
